# EUROPEAN PATENT SPECIFICATION

(11) **EP 3 238 250 B1**
(45) Date of publication and mention of the grant of the patent: **04.05.2022**
(21) Application number: 14891616.6
(22) Date of filing: 24.12.2014
(51) Int. Cl.: H01L 25/065, H01L 25/16, H01L 23/48, H01L 23/522, H01L 23/00, H01L 23/64, H01L 25/18, H01L 49/02

(54) **INTEGRATED PASSIVE COMPONENTS IN A STACKED INTEGRATED CIRCUIT PACKAGE**
INTEGRIERTE PASSIVE BAUTEILE IN EINER GESTAPELTEN INTEGRIERTEN SCHALTUNGSPACKUNG
COMPOSANTS PASSIFS INTÉGRÉS DANS UN BOÎTIER DE CIRCUITS INTÉGRÉS EMPILÉS

(43) Date of publication of application: 01.11.2017
(73) Proprietor: Intel Corporation, Santa Clara, CA 95054 (US)
(72) Inventor: RUSU, Stefan, Sunnyvale, California 94087 (US); GARDNER, Donald, Los Altos, California 94022 (US)
(74) Representative: Rummler, Felix
(86) International application number: PCT/US2014/072395
(87) International publication number: WO 2016/105425

(56) References cited:
- US-A1- 2003 081 389
- US-A1- 2005 285 243
- US-A1- 2006 109 623
- US-A1- 2011 042 795
- US-A1- 2012 112 352
- US-A1- 2012 112 352
- US-A1- 2013 003 310
- US-A1- 2014 268 615
- None

## Description

### FIELD

The present description relates to the field of integrating passive components in a stacked processor package and in particular to integrating components for power delivery.

### BACKGROUND

High power processor packages are developing to have more processing cores and processing cores of different types. These cores require power delivery from an external power supply. In many cases an integrated voltage regulator is included on a die as a part of a processing core. The voltage regulator requires large passive components such as inductors and capacitors that are placed in some external location. With more cores being used, more external passive components are required.

In other examples, the voltage regulator is in a separate die with the uncore circuitry (such as I/O, memory controller, and power control unit) and is packaged with the die stacked with the processor cores over the die and with a voltage regulator for each core. This allows more space in the die with the microprocessor cores to be made available and isolates the power circuitry from the core processing circuitry. Still the large passive inductors and capacitors for the voltage regulator are placed in some external location that is reached through vias, connection bumps, or some other means. The passive components provide higher Q factors when isolated from high speed digital circuitry and from high density interconnection grids. They also provide higher Q factors when they are made large compared to the components of the processing die or even the voltage regulator die. Also, the passive components perform better when they are located near the core processing circuitry.

US2003/081389A1 relates to a voltage regulation module and system for an integrated circuit die. The voltage regulation module includes an interposer situated in a stack between a substrate and the integrated circuit die. The interposer includes a hybrid array of voltage regulation elements for receiving voltage from the power supply and for down-converting the voltage from the power supply into a regulated voltage supplied to the integrated circuit die.

US2014/268615A1 relates to a two-stage power delivery network includes a voltage regulator and an interposer. The interposer includes a packaging substrate having an embedded inductor. The embedded inductor includes a set of traces and a set of through substrate vias at opposing ends of the traces. The interposer is coupled to the voltage regulator. The two-stage power delivery network also includes a semiconductor die supported by the packaging substrate. The two-stage power delivery network also includes a capacitor that is supported by the packaging substrate.

US2012/0112352A1 relates to an integrated circuit system having an interposer and an integrated circuit with first and second bond pads, the integrated circuit die bonded to the interposer using the first bond pads. The integrated circuit having circuit blocks, that operate at different operating voltages and voltage regulator modules die bonded to the second bond pads of the integrated circuit.

### SUMMARY OF THE INVENTION

The invention is defined in the claims. In the following description, any embodiment referred to and not falling within the scope of the claims is merely an example useful to the understanding of the invention.

### BRIEF DESCRIPTION OF THE DRAWINGS

Embodiments of the invention are illustrated by way of example, and not by way of limitation, in the figures of the accompanying drawings in which like reference numerals refer to similar elements.
Figure 1 is a cross-sectional side view diagram of a 3-D stacked face to back package with power delivery components on first and second dies according to an embodiment.
Figure 2 is a cross-sectional side view diagram of an alternative stacked face-to-back package according to an embodiment.
Figure 3 is a cross-sectional side view diagram of a stacked face-to-face package according to an embodiment.
Figure 4 is a cross-sectional side view diagram of an alternative stacked face-to-face package according to an embodiment.
Figure 5 is a cross-sectional side view diagram of magnetic core inductors formed in a recess of a die according to an embodiment.
Figure 6 is a cross-sectional side view diagram of magnetic core inductors formed in a recess of a die with angled side walls according to an embodiment.
Figure 7 is a cross-sectional side view diagram of magnetic core inductors formed in pores of a die . Not claimed.
Figure 8 is a cross-sectional side view diagram of stacked face-to-back package mounted to a . Not claimed.
Figure 9 is a block diagram of a computing device incorporating a package with passive components . Not claimed.

### DETAILED DESCRIPTION

In embodiments, inductors with magnetic material also known as magnetic core inductors (MCI) are integrated on a bottom (uncore) die of a 3D-stacked processor. The stacked processors are in topologies that are particularly suited for integrating a FIVR (Fully Integrated Voltage Regulator) into the dies. The uncore die includes uncore circuitry such as input/output circuitry, a memory controller, a power control unit, etc. Some embodiments may also include high density capacitors on the back side of the bottom (uncore) die as an alternative to or in addition to multi-layer MIM (Metal-Insulator-Metal) capacitors on the top (core) die. This approach simplifies the package design because the package requires fewer layers and fewer design restrictions. This approach also opens up more room on the package for effective VIN (Input Voltage) decoupling capacitors. While the bottom (uncore) die is made more complex by the addition of the inductors, it is simplified by removing connections through the bottom die between the FIVR circuitry and the inductors in the package.

Magnetic core inductors may be integrated either on the back-side or the front side of the uncore (bottom) die. This avoids having the FIVR output go from the top or bottom die back into the package to connect to inductors in the package. It also reduces the number of connection bumps on the uncore (bottom) die. The MCIs on the bottom die can provide twenty or thirty times higher inductance density and a significantly smaller volume and thickness as compared to the ACI in the package, which alleviates the impact of the core area scaling. For a FIVR design located on the bottom die to supply power to cores on the top die, the best location for the inductors is in the same bottom die. High density 3D MIM capacitors and planar MIM capacitors may also be added on the back or front of the bottom (uncore) die to avoid the cost and complexity of fabricating the multi-layer MIM capacitors on the top die. In addition, by including the MCI in the same die with the FIVR, the FIVR may be tested independently of the package assembly.

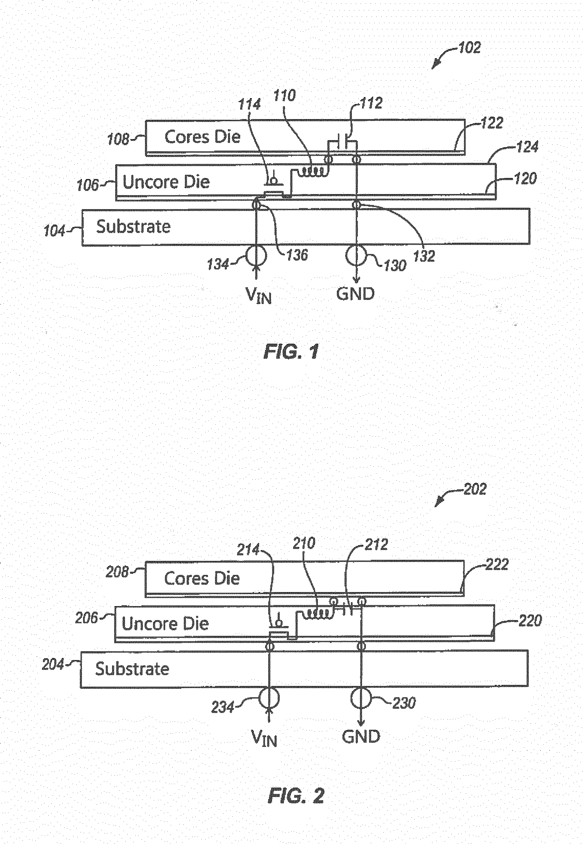

Figure 1 is a side cross-sectional diagram of a 3D-stacked server configuration package 102. There is a package substrate 104 or substrate to be coupled to a circuit board directly or through a socket. The substrate may be formed of ceramic, silicon, build-up layers, or any other material to provide connection pads on the top 132, 136 and bottom 130, 134 surfaces of the substrate as well as connection routing between the top and bottom and some circuit components on or in the substrate. An uncore die 106 is connected to the substrate and located over the substrate. A cores die 108 is coupled to the uncore die and located over the uncore die. The uncore die typically provides power management, input/output signaling, and other functions for the cores die. While the lower die is referred to herein as an uncore die, any other type of supporting die may be used that performs similar functions and the die may be called by different names. The uncore may also include processing resources, radio, amplifier, or other types of circuitry used, for example, in a system on a chip (SOC).

The cores die provides high speed computational and processing functions using one or more processing cores integrated onto a die. The cores die is attached such that the circuitry 122 is facing towards the substrate which allows for a heat sink 124 to be attached to the backside of the cores die. There may be different types of cores that are optimized for different functions, including general purpose computing, digital signal processing, and graphics processing cores. The specific functions of the dies may be adapted to suit different applications. There may be more cores dies and there may be additional dies over the uncore for other functions such as memory, input/output signaling, co-processing, etc.

There is a FIVR block (not shown) on each landing slot (not shown) in the uncore (bottom) die that powers the core located directly above it. There are also FIVR blocks that power the uncore die itself. The techniques presented herein may be applied to integrated LC filter components for FIVR components regardless of the components that are being powered. In addition, while the description herein is generally directed to a FIVR, the described structures and techniques may be adapted to other types of voltage regulators or voltage converters. The voltage regulators may be a switching voltage regulator (commonly known as a buck voltage regulator), a switched capacitor voltage regulator, a charge pump, a low drop-out voltage regulator, a linear voltage regulator or a combination of these types of voltage regulators such as a hybrid switch capacitor combined. Not all of these types of voltage regulators use inductors, but capacitors are typically used in all voltage regulators to reduce noise from circuit switching. The particular choice of passive device may be adapted to suit the corresponding power supply circuit. The use of the term "FIVR" is not intended to require any particular voltage regulator circuitry, connections or components.

The uncore die 106 is attached to the substrate so that the front side of the die is facing the substrate. This allows circuitry 120 of the front side of the die to be directly coupled to the substrate through mating connection pads 132, 136. As mentioned above, this circuity may include power, clocking, input/output, and other circuity depending on the particular application. The cores die similarly is attached to the uncore die so that the front side of the cores die is facing the back side of the uncore die. This may be referred to as a F2B (front-to-back or face-to-back) configuration. The circuitry 122 of the cores die is coupled directly to the back side of the uncore die and may be connected to the circuitry of the uncore die using TSVs (Through Silicon Vias) or any of a variety of other techniques.

A magnetic core inductor 110 is integrated on the back side of the uncore die, while high-density MIM capacitors 112 are integrated in the top die. The capacitors may be formed using any of a variety of different techniques including a multi-layer planar design. The input voltage VIN from an external source, typically but not necessarily on the circuit board, is coupled through a pad 134 to the substrate 104 and through substrate connections 136 to a voltage regulator circuit 114 such as a FIVR. The voltage regulator couples the power to the MCI 110 and then through the capacitor 112 to power at least a part of the cores die. The return path for the current from the cores die and the connections to the capacitor are looped back through a substrate connection 132 through the substrate to a ground connection GND 130 through the uncore die and the substrate.

The voltage regulator circuit is represented by a transistor 114 to suggest a pulse width modulation (PWM) of the power supplied to the cores die 108. In some embodiments, the regulated power supply will be based around one or more switched power transistors to generate a controllable duty cycle of the input voltage. The operation of the switching power transistor is controlled by a power regulation circuit (not shown) that receives a control signal to drive the transistor gate. The power supply pulses are then supplied to the inductors 110 and capacitors 112 to even out the pulsed power to a constant voltage level. Other types of power supplies may be used as alternatives to suit particular cores.

While the present disclosure is provided in the context of a FIVR or other type of voltage regulator, the described configurations and embodiments may be applied to a variety of different power supply circuits and systems and to passive components for any such system. The power supply circuit 114 may be voltage regulator as described, a voltage converter, or any other type of power supply circuit. Similarly while both an inductor 110 and a capacitor 112 are shown, the number and types of passive components and their connection with the circuitry may be adapted to suit the particular power supply circuit. While only one voltage regulator is shown there may be one or more voltage regulators for each processing core of the cores die. There may also be voltage regulators to power components in the uncore die. The cores die may have two or more processing cores of similar or different types. In one embodiment there may be 36 cores including high speed, low power, graphics, accelerators and FPGA (Field Programmable Gate Array) processors included in a single cores die. Other and additional cores may be used depending on the particular implementation.

The package of Figure 1 and any of the other embodiments may be finished by adding a cover, a heat spreader, or some other or additional components. Alternatively, connections can be made using bonding wires around the perimeter of the uncore die to the package. The dies may be covered in molding compound for protection and stability. Additional parts such as amplifiers, radio frequency components, and digital signal processors may also be added on or in the package.

Figure 2 is a cross-sectional side view diagram of an alternative stacked server configuration package 202 in which a capacitor 212 has been moved from a cores die 208 to the back of an uncore (bottom) die 206. The capacitor may be formed in the same space as the inductor. The package has a package substrate 204 or substrate with the circuitry 220 of a front side of the uncore die facing and coupled to the substrate 204. Circuitry 222 of a front side of the cores die 208 is coupled to the back side of the uncore die.

The substrate is coupled to a VIN connector 234 directly or through a socket. The VIN is conditioned through a voltage regulator 214 to an inductor 210 on the back side of the uncore die. This inductor is constructed and positioned similar to the inductor 110 of Figure 1. The inductor 210 is coupled to a capacitor 212 now on the back side of the uncore die to route power to the cores die and eventually looped back through the uncore die 206 and the substrate 204 to a GND connection 230. The positioning of the capacitor 212 on the uncore die further simplifies the construction of the cores die and further simplifies the connections between the uncore die and the cores die. The capacitor 212 can be a planar MIM capacitor or a 3D MIM capacitor.

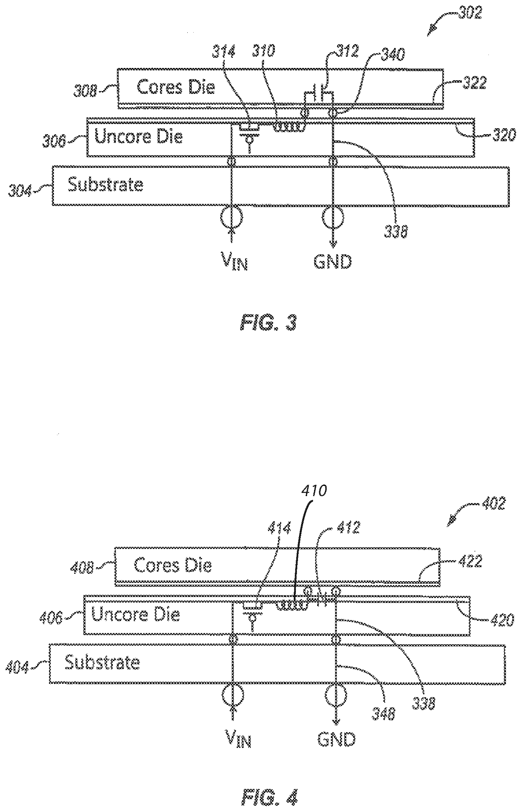

Figure 3 is a similar cross-sectional side view diagram of an alternate implementation of a package suitable for F2F (face-to-face) stacking. In this embodiment, the package 302 has a substrate 304 with power, VIN, GND, and other external connections for data and control, for example. An uncore die 306 is coupled to the substrate through its back side. Through silicon vias 338 connect the substrate through the back side of the die to a voltage regulator 314 on the front side of the die. Alternatively, bonding wire connected to the circuitry 320 around the perimeter of the uncore die 306 can be used to connect to the substrate. The front side of the uncore die faces the front side of a core die 308. The two dies are connected, for example using a solder ball grid or micro-bump solder grid 340. An inductor 310 is formed on the front side of the uncore die between the solder bumps and coupled to the voltage regulator. A capacitor 312 is formed on the front side of the cores die and coupled to the inductor through one or more of the solder ball connections. The capacitor is then coupled to circuitry of the front side of the die that forms a processing core.

In this example, the front side of the first die 306 is identified as the side that includes the circuitry 320 formed on the die through photolithography and other processes. Similarly, the front side of the second die 308 is identified as the side that includes the circuitry 322 formed on the second die.

The inductors 310 may be formed with magnetic material as MCIs (Magnetic Core Inductors or inductors with magnetic material) for example and the capacitors may be formed as MIM (Metal-Insulator-Metal) caps. Both may be fabricated on the front side or the top of the uncore die, the same side as the transistors. In the embodiments of Figures 3 and 4, the current through the TSVs 338 for VIN would be reduced compared to a TSV that carries current between a voltage regulator and the inductors and capacitors. The power prior to the voltage regulator has a higher voltage and lower current. As a result, in comparison to a system with the inductors in the substrate, fewer TSVs are required and the signals between the dies have a shorter distance to travel. Reducing the distance for die-to-die signal improves performance with lower cost because die-to-die signals likely have less buffering and less amplification and are likely to be more numerous.

Figure 4 is a similar cross-sectional side view diagram to that of Figure 3 in which the 412 capacitor has been moved from the front side of a cores die 408 to the front side of an uncore die 406. In addition, 3D high-density capacitors could be incorporated on the front side of the uncore die for use by the voltage regulator and on the backside of the uncore die for the input Vcc to the voltage regulator for decoupling.

In Figure 4, the same F2F configuration of Figure 3 is used. A package 402 has a first die 406 coupled to and over a substrate 404. A second die 408 is coupled to the first die in a F2F configuration so that the circuitry 420 of the first die is facing the circuitry 422 of the second die. The first die includes a voltage regulator 414 such as a FIVR, one or more inductors 410 and one or more capacitors 412 coupled to the voltage regulator. The inductors and capacitors are formed on the front side of the first die between solder bumps that connect the first and the second die to each other. In this embodiment as in the example of Figure 3, vias 338 to external power run through the first die to the back side of the first die to connect to the substrate. Additional vias 348 run through the substrate to connect through solder bumps to the external power supply. As a result, the connections between the voltage regulator and the corresponding processing core are short and do not require any through-silicon vias. The connections to external power are comparatively long. Alternatively, bonding wires can be used along the perimeter of the uncore die to electrically connect to the substrate.

In Figures 1-4, the inductors and capacitors are placed in the gap between the uncore and cores dies. The vertical height of this space is typically determined by the height of the connections between the two dies. These connections may be metal micro-bump connections, solder bumps, molded studs, thermosonic or thermo-compression bonds using copper-copper, gold-gold, or other metals or electrically conductive polymers, or a tape-and-reel process. Wire bonds using, for example thermosonic bonding or wedge bonds, can also be used to connect the uncore die to the substrate. In some embodiments, a small space results from bonding between the uncore die and the substrate where there is no metal to metal contact. An electrically-insulating adhesive may be used as an underfill in this space. The underfill provides a stronger mechanical connection, provides a heat bridge, and ensures that the solder joints are not stressed due to differential heating of the chips. The underfill also distributes the thermal expansion mismatch between the chips by conducting heat.

Depending on the construction of the inductors and capacitors and the required L, C and other values, the height of the L and C components may be greater than the vertical gap created by the micro-bump connections. In order to provide more space for the L and C components, recesses may be formed on the corresponding surface of the appropriate die. The L and C components may then be formed in or positioned in these recesses.

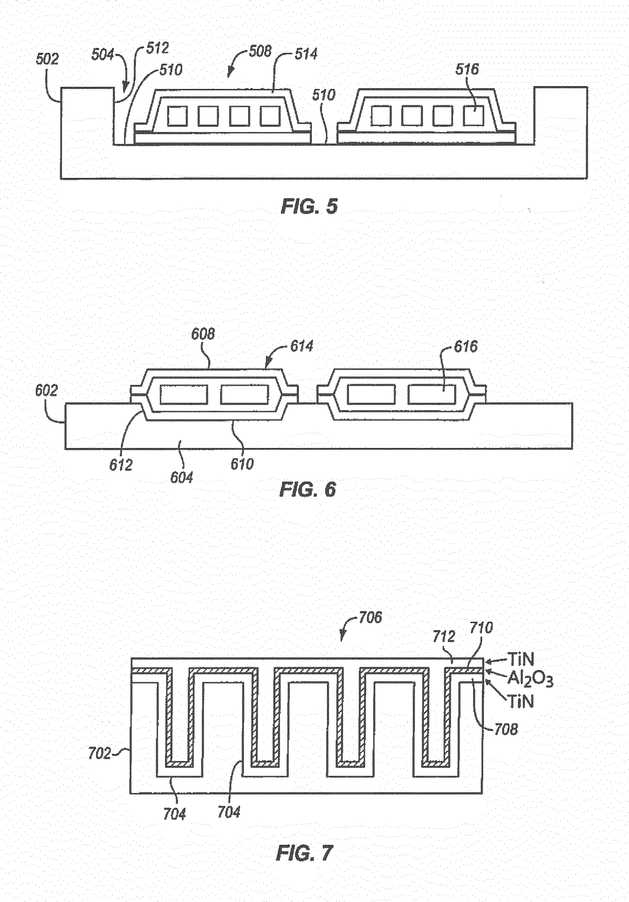

Figure 5 shows an example of a magnetic core inductor formed in a recess of a die. The same approach may be applied to capacitors and other types of inductors. The die 502 is shown in cross-section. A notch 504 has been cut in the die with a vertical wall 512 and a bottom floor 510. The notch is formed as a recess or indent by etching, drilling, laser machining, or by another process removing material from the die to form the recess or indentation. The notch increases the distance from the top die to the bottom floor of the notch in the uncore die. The integrated passive components may be built in one or more different notches on the back side or even the front side of the bottom die, depending on the package configuration.

As shown, a magnetic core inductor is 506 is formed or positioned in the notch. The inductor has copper windings 516 surrounded by magnetic core material 514. The inductors may be formed in any of a variety of different ways. The inductor device may be a stripe inductor, spiral inductor, solenoid inductor, torus inductor, an inductor formed in a V-groove etched into the silicon, or may be a coupled inductor or transformer. In some embodiments, the lower half of the magnetic material is first deposited. The copper conductors are formed over the lower half and then a top half is deposited. An insulator may be used to isolate the copper wires from the magnetic material. The inductors are coupled to wiring line traces (not shown) that traverse from the notch to an appropriate wiring line or solder bump of the uncore die. This wiring line allows the inductor to be coupled to the voltage regulator on one side and one or more capacitors on the other side or to any other components as may be desired depending on the implementation.

Figure 6 is a cross-sectional side view diagram of a further variation in which a notch 604 in a silicon die 602 may be tapered to improve the step coverage of the magnetic material 614 of an inductor 608 which improves the quality factor of the inductor. The notch has a bottom floor 610 and a side wall 612, but in this case the side wall is formed at an angle so that the walls taper in towards the floor of the notch. The magnetic core material 614 may then be formed for the lower half by depositing the core material directly over the bottom floor of the notch and up the angled side walls of the notch. This will improve the step coverage and the performance of the inductor by providing a better path for the magnetic flux. The copper windings 616 are formed over the lower half of the core and then the top half of the inductor is formed over the copper windings. As shown, each notch may be formed with a size to accommodate a single inductor. The process of forming the notch may be used to control the size of the inductor. As in the example of Figure 5 wiring traces may be deposited or formed in any other way to connect the inductors to other components.

High-density capacitors may also be formed in the surface of a silicon die. Not claimed: Figure 7 shows a silicon die 702. Pores 704 may be etched into the front or back side of the uncore die 702 as shown to show a series of parallel channels or grooves. The channels may then be lined with a first conductor layer 708 such as TiN, TaN, Cu, or any other desired material. The first conductor layer may then be covered in a dielectric layer 710 such as Al₂O₃, HfO₂, SiN, SiO₂, or any other desired dielectric. The dielectric may then be covered with a second conductor layer 712 of the same or a different material as the first layer 708. In the example of Figure 7, the pores are completely filled with the second conductor layer. Depositions techniques for forming these layers in 3D trenches or on planar surfaces include atomic layer deposition (ALD), electroplating, electroless plating, chemical vapor deposition (CVD) sputtering, and evaporation.

The resulting MIM capacitor takes very little of the vertical space between the dies because most of its material is embedded into the pores cut into the die. The alternating layers of metal and insulator may be formed to produce a particular capacitance. These capacitors can be formed either on the uncore as in Figure 2 and 4 or on the cored die as in Figure 1 and 3. The may be used for a voltage regulator output. They may also be used for the input voltage VIN of the microchip as decoupling capacitors. The thickness of the dielectric may be adjusted to accommodate the higher voltages for the input voltage separately from the output voltage.

### Not claimed:

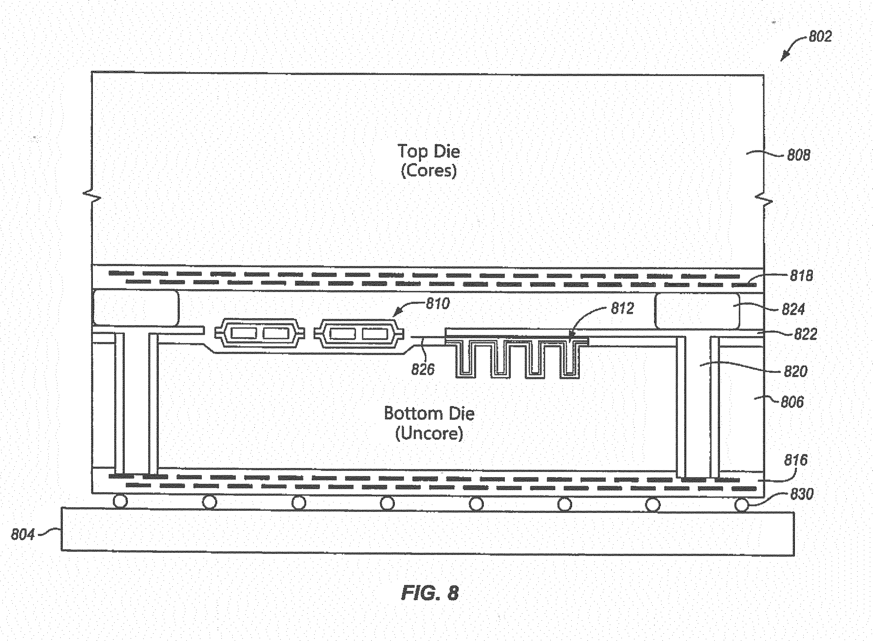

Figure 8 is a cross-sectional side view diagram of parts of a 3-D stacked F2B package 802 that includes magnetic core inductors 810 and 3D MIM capacitors 812 integrated in the 3D-stacked system using a face-to-back stacking. Both the inductors and capacitors are embedded in the back side of a bottom die 806, to enable a natural path from a FIVR circuit in a circuitry layer 816 of the bottom die to a load in a circuitry layer 818 of the top die.

A redistribution layer 822 may be formed on the back side of the die to connect the inductors and capacitors between TSVs 820 on the bottom die 806 and micro-bumps 824 on the top die 808. The TSVs connect the inductors and capacitors to the voltage regulator on the front side of the bottom die. Specific routing layers 826 may be used to connect the inductors 810 to the capacitors 812. The bottom die is also coupled to a substrate 804 for connection to external components. The redistribution layer 822 may also be used as a heat spreader to help remove heat generated by the uncore die. A heat sink (not shown) may be added to make contact with the perimeter of the uncore die. The uncore die may be made larger than the cores die to provide a simpler physical contact with the uncore die.

The stacked packages described herein provide significant benefits. As an example, area scaling concerns are alleviated for FIVR LC filter components that have to fit in the footprint of one core. By forming or positioning the LC filter components on or in the bottom die, high Q factors can be obtained without forcing higher precision on the simpler substrate and without consuming extensive space on the high speed dense fabrication technology processing core.

By removing the LC components from the substrate, the cost and complexity of the substrate is reduced. In addition, fewer connection bumps are required on the uncore die to support the FIVR support. Instead of connecting to LC passive components in the substrate using bumps, the FIVR connects directly to LC components using TSVs and redistribution layers in the top core. The connection bumps to the substrate of the top die are no longer needed.

### Not claimed:

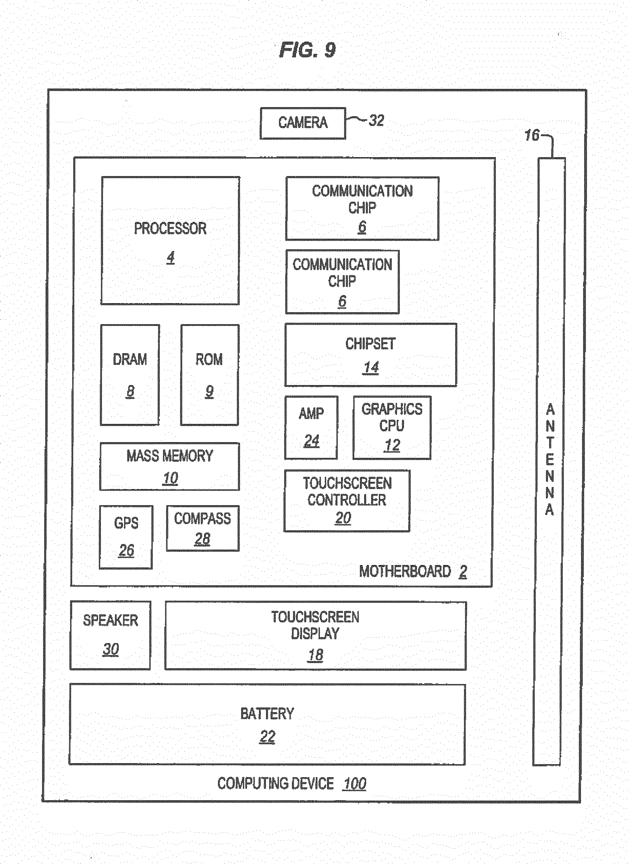

Figure 9 illustrates a computing device 100 in accordance with one implementation of the invention. The computing device 100 houses a system board 2. The board 2 may include a number of components, including but not limited to a processor 4 and at least one communication package 6. The communication package is coupled to one or more antennas 16. The processor 4 is physically and electrically coupled to the board 2.

### Not claimed:

Depending on its applications, computing device 100 may include other components that may or may not be physically and electrically coupled to the board 2. These other components include, but are not limited to, volatile memory (e.g., DRAM) 8, non-volatile memory (e.g., ROM) 9, flash memory (not shown), a graphics processor 12, a digital signal processor (not shown), a crypto processor (not shown), a chipset 14, an antenna 16, a display 18 such as a touchscreen display, a touchscreen controller 20, a battery 22, an audio codec (not shown), a video codec (not shown), a power amplifier 24, a global positioning system (GPS) device 26, a compass 28, an accelerometer (not shown), a gyroscope (not shown), a speaker 30, a camera 32, and a mass storage device (such as hard disk drive) 10, compact disk (CD) (not shown), digital versatile disk (DVD) (not shown), and so forth). These components may be connected to the system board 2, mounted to the system board, or combined with any of the other components.

### Not claimed:

The communication package 6 enables wireless and/or wired communications for the transfer of data to and from the computing device 100. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication package 6 may implement any of a number of wireless or wired standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, Ethernet derivatives thereof, as well as any other wireless and wired protocols that are designated as 3G, 4G, 5G, and beyond. The computing device 100 may include a plurality of communication packages 6. For instance, a first communication package 6 may be dedicated to shorter range wireless communications such as Wi-Fi and Bluetooth and a second communication package 6 may be dedicated to longer range wireless communications such as GPS, EDGE, GPRS, CDMA, WiMAX, LTE, Ev-DO, and others.

### Not claimed:

Any one or more of the chips may be packaged as described herein or several of the chips may be combined into a single package using passive components for power delivery as described.

In various implementations, the computing device 100 may be a server, a workstation, a laptop, a netbook, a notebook, an ultrabook, a smartphone, a tablet, a personal digital assistant (PDA), an ultra mobile PC, a mobile phone, a printer, a scanner, a monitor, a set-top box, an entertainment control unit, a digital camera, a portable music player, or a digital video recorder or devices termed internet of things (IoT). In further implementations, the computing device 100 may be any other electronic device, such as a pen, a wallet, a watch, or an appliance that processes data.

### Not claimed:

Embodiments may be implemented as a part of one or more memory chips, controllers, CPUs (Central Processing Unit), microchips or integrated circuits interconnected using a motherboard, an application specific integrated circuit (ASIC), and/or a field programmable gate array (FPGA).

## Claims

1. An apparatus comprising:
a substrate (104; 204);
a first die (106; 206) coupled to the substrate over the substrate, the first die including a power supply circuit (114; 214) coupled to the substrate to receive power; and
a second die (108; 208) having a processing core and coupled to the first die over the first die, the second die being coupled to the power supply circuit to power the processing core; the apparatus further comprising a passive device including a magnetic core inductor (110; 210) attached to the first die and coupled to the power supply circuit, wherein the first die has a front side including circuitry (120; 220) facing the substrate and a back side facing the second die and wherein the passive device is positioned on the back side.

2. The apparatus of Claim 1, wherein the front side of the first die is coupled to the second die using through silicon vias through the first die.

3. The apparatus of Claim 1 or 2, wherein the back side of the first die is coupled to the substrate using bonding wires.

4. An apparatus comprising:
a substrate (304; 404);
a first die (306; 406) coupled to the substrate over the substrate, the first die including a power supply circuit (314; 414) coupled to the substrate to receive power; and
a second die (308; 408) having a processing core and coupled to the first die over the first die, the second die being coupled to the power supply circuit to power the processing core; the apparatus further comprising
a passive device including a magnetic core inductor (310; 410; 506) attached to the first die and coupled to the power supply circuit, wherein the first die has a front side including circuitry (320; 420) facing the second die and a back side facing the substrate and wherein the passive device is formed on the front side of the first die.

5. The apparatus of Claim 4, wherein the first die is connected to the second die using solder bumps and wherein the passive device is positioned on the front side of the first die between the solder bumps.

6. The apparatus of Claim 4 or 5, wherein the first die is connected to the second die using either micro-bump, molded stud, thermosonic, or thermo-compression bonds and wherein the passive device is positioned on the front side of the first die between the bonds.

7. The apparatus of Claim 5, wherein the front side of the first die has a recess between the solder bumps and wherein the passive device is positioned inside the recess.

8. The apparatus of Claim 7, wherein the recess has a bottom floor (510) and side walls (512, 612), wherein the side walls are tapered in towards the bottom floor, and wherein the passive device has a magnetic layer on the tapered side walls.

9. The apparatus of any one or more of the above claims, wherein the first die is a silicon die and wherein the magnetic core inductor is an inductor with magnetic material formed on a surface of the silicon die.

10. The apparatus of any one or more of the above claims, wherein the passive device includes capacitors coupled to inductors, the capacitors being formed on a surface of the first die.

11. The apparatus of Claim 10, wherein the first die is a silicon die and wherein the capacitors are metal-insulator-metal capacitors.

12. The apparatus of Claim 10 or 11, wherein the passive device further comprises either 3D metal-insulator-metal capacitors, planar metal-insulator-metal capacitors, stripe inductors, spiral inductors, solenoid inductors, or torus inductors.

13. The apparatus of any one or more of the above claims, wherein the substrate comprises power decoupling capacitors coupled between an external power supply and the power supply circuit.

14. The apparatus of any one or more of the above claims, wherein the power supply circuit comprises either a voltage converter, a switched capacitor voltage converter, a voltage regulator or a fully integrated voltage regulator.

## Patentansprüche

1. Einrichtung, die Folgendes umfasst:
ein Substrat (104; 204);
einen ersten Chip (106; 206), der über das Substrat mit dem Substrat gekoppelt ist, wobei der erste Chip eine Stromversorgungsschaltung (114; 214) aufweist, die mit dem Substrat gekoppelt ist, um Strom zu erhalten; und
einen zweiten Chip (108; 208) mit einem Verarbeitungskern, der über den ersten Chip mit dem ersten Chip gekoppelt ist, wobei der zweite Chip mit der Stromversorgungsschaltung gekoppelt ist, um den Verarbeitungskern zu versorgen;
wobei die Einrichtung ferner Folgendes umfasst:
eine passive Vorrichtung mit einem Magnetkerninduktor (110; 210), die an dem ersten Chip angebracht und mit der Stromversorgungsschaltung gekoppelt ist, wobei der erste Chip eine Vorderseite mit einer dem Substrat zugewandten Schaltung (120; 220) und eine dem zweiten Chip zugewandte Rückseite aufweist, und wobei die passive Vorrichtung auf der Rückseite positioniert ist.

2. Einrichtung nach Anspruch 1, wobei die Vorderseite des ersten Chips mit dem zweiten Chip unter Verwendung von Kopplungs-Silizium-Durchkontaktierungen durch den ersten Chip gekoppelt ist.

3. Einrichtung nach Anspruch 1 oder 2, wobei die Rückseite des ersten Chips mit Hilfe von Bonddrähten mit dem Substrat gekoppelt ist.

4. Einrichtung, die Folgendes umfasst:
ein Substrat (304; 404);
einen ersten Chip (306; 406), der über das Substrat mit dem Substrat gekoppelt ist, wobei der erste Chip eine Stromversorgungsschaltung (314; 414) aufweist, die mit dem Substrat gekoppelt ist, um Strom zu erhalten; und
einen zweiten Chip (308; 408) mit einem Verarbeitungskern, der über den ersten Chip mit dem ersten Chip gekoppelt ist, wobei der zweite Chip mit der Stromversorgungsschaltung gekoppelt ist, um den Verarbeitungskern zu versorgen;
wobei die Einrichtung ferner Folgendes umfasst:
eine passive Vorrichtung mit einer Magnetkerninduktivität (310; 410; 506), die an dem ersten Chip angebracht und mit der Stromversorgungsschaltung gekoppelt ist, wobei der erste Chip eine Vorderseite mit einer Schaltung (320; 420), die dem zweiten Chip zugewandt ist, und eine dem Substrat zugewandte Rückseite aufweist, und wobei die passive Vorrichtung auf der Vorderseite des ersten Chips ausgebildet ist.

5. Einrichtung nach Anspruch 4, wobei der erste Chip unter Verwendung von Löthöckern mit dem zweiten Chip verbunden ist, und wobei die passive Vorrichtung auf der Vorderseite des ersten Chips zwischen den Löthöckern positioniert ist.

6. Einrichtung nach Anspruch 4 oder 5, wobei der erste Chip mit dem zweiten Chip verbunden ist, indem entweder Mikrobump-, Gussbolzen-, Thermoschall- oder Thermokompressionsbindungen verwendet werden, und wobei die passive Vorrichtung auf der Vorderseite des ersten Chips zwischen den Bindungen positioniert ist.

7. Einrichtung nach Anspruch 5, wobei die Vorderseite des ersten Chips eine Aussparung zwischen den Lötstellen aufweist, und wobei die passive Vorrichtung innerhalb der Aussparung angeordnet ist.

8. Einrichtung nach Anspruch 7, wobei die Aussparung einen Boden (510) und Seitenwände (512, 612) aufweist, wobei die Seitenwände zum Boden hin verjüngt sind, und wobei die passive Vorrichtung eine magnetische Schicht auf den verjüngten Seitenwänden aufweist.

9. Einrichtung nach einem oder mehreren der obigen Ansprüche, wobei der erste Chip ein Siliziumchip ist, und wobei der Magnetkerninduktor ein Induktor mit magnetischem Material ist, das auf einer Oberfläche des Siliziumchips ausgebildet ist.

10. Einrichtung nach einem oder mehreren der obigen Ansprüche, wobei die passive Vorrichtung Kondensatoren aufweist, die mit Induktoren gekoppelt sind, wobei die Kondensatoren auf einer Oberfläche des ersten Chips ausgebildet sind.

11. Einrichtung nach Anspruch 10, wobei der erste Chip ein Siliziumchip ist, und wobei die Kondensatoren Metall-Isolator-Metall-Kondensatoren sind.

12. Einrichtung nach Anspruch 10 oder 11, wobei die passive Vorrichtung ferner entweder 3D-Metall-Isolator-Metall-Kondensatoren, planare Metall-Isolator-Metall-Kondensatoren, Streifeninduktoren, Spiralinduktoren, Solenoidinduktoren oder Torusinduktoren umfasst.

13. Einrichtung nach einem oder mehreren der obigen Ansprüche, wobei das Substrat Leistungsentkopplungskondensatoren umfasst, die zwischen einer externen Stromversorgung und der Stromversorgungsschaltung gekoppelt sind.

14. Einrichtung nach einem oder mehreren der obigen Ansprüche, wobei die Stromversorgungsschaltung entweder einen Spannungswandler, einen Spannungswandler mit geschalteten Kondensatoren, einen Spannungsregler oder einen voll integrierten Spannungsregler umfasst.

## Revendications

1. Appareil comprenant :
un substrat (104 ; 204) ;
une première puce (106 ; 206) couplée au substrat par-dessus le substrat, la première puce comprenant un circuit d'alimentation (114 ; 214) couplé au substrat pour recevoir une puissance ; et
une seconde puce (108 ; 208) présentant un cœur de traitement et couplée à la première puce par-dessus la première puce, la seconde puce étant couplée au circuit d'alimentation pour alimenter le cœur de traitement ; l'appareil comprenant en outre
un dispositif passif comprenant un inducteur à noyau magnétique (110 ; 210) fixé à la première puce et couplé au circuit d'alimentation, dans lequel la première puce présente une face avant comportant des circuits (120 ; 220) qui fait face au substrat et une face arrière qui fait face à la seconde puce et le dispositif passif étant positionné sur la face arrière.

2. Appareil selon la revendication 1, dans lequel la face avant de la première puce est couplée à la seconde puce à l'aide de trous d'interconnexion à travers le silicium à travers la première puce.

3. Appareil selon la revendication 1 ou 2, dans lequel la face arrière de la première puce est couplée au substrat à l'aide de fils de liaison.

4. Appareil comprenant :
un substrat (304 ; 404) ;
une première puce (306 ; 406) couplée au substrat par-dessus le substrat, la première puce comportant un circuit d'alimentation (314 ; 414) couplé au substrat pour recevoir une puissance ; et
une seconde puce (308 ; 408) présentant un cœur de traitement et couplée à la première puce par-dessus la première puce, la seconde puce étant couplée au circuit d'alimentation pour alimenter le noyau de traitement ; l'appareil comprenant en outre
un dispositif passif comportant un inducteur à noyau magnétique (310 ; 410 ; 506) fixé à la première puce et couplé au circuit d'alimentation, dans lequel la première puce présente une face avant comportant des circuits (320 ; 420) qui fait face à la seconde puce et une face arrière qui fait face au substrat et le dispositif passif étant formé sur la face avant de la première puce.

5. Appareil selon la revendication 4, dans lequel la première puce est connectée à la seconde puce à l'aide de perles de soudure et dans lequel le dispositif passif est positionné sur la face avant de la première puce entre les perles de soudure.

6. Appareil selon la revendication 4 ou 5, dans lequel la première puce est connectée à la seconde puce à l'aide de liaisons par micro-pertes, goujons moulés, liaisons thermosoniques ou liaisons par thermocompression et dans lequel le dispositif passif est positionné sur la face avant de la première puce entre les liaisons.

7. Appareil selon la revendication 5, dans lequel la face avant de la première puce présente un renfoncement entre les perles de soudure et dans lequel le dispositif passif est positionné à l'intérieur du renfoncement.

8. Appareil selon la revendication 7, dans lequel le renfoncement présente un fond inférieur (510) et des parois latérales (512, 612), dans lequel les parois latérales sont coniques vers le fond inférieur, et dans lequel le dispositif passif présente une couche magnétique sur les parois latérales coniques.

9. Appareil selon n'importe quelle(s) une ou plusieurs revendications précédentes, dans lequel la première puce est une puce en silicium et dans lequel l'inducteur à noyau magnétique est un inducteur à matériau magnétique formé sur une surface de la puce en silicium.

10. Appareil selon n'importe quelle(s) une ou plusieurs revendications précédentes, dans lequel le dispositif passif comporte des condensateurs couplés à des inducteurs, les condensateurs étant formés sur une surface de la première puce.

11. Appareil selon la revendication 10, dans lequel la première puce est une puce en silicium et dans lequel les condensateurs sont des condensateurs métal-isolant-métal.

12. Appareil selon la revendication 10 ou 11, dans lequel le dispositif passif comporte en outre des condensateurs métal-isolant-métal 3D, des condensateurs métal-isolant-métal planaires, des inducteurs en ruban, des inducteurs en spirale, des inducteurs solénoïdes ou des inducteurs toriques.

13. Appareil selon n'importe quelle(s) une ou plusieurs revendications précédentes, dans lequel le substrat comprend des condensateurs de découplage de puissance couplés entre une alimentation externe et le circuit d'alimentation.

14. Appareil selon n'importe quelle(s) une ou plusieurs revendications précédentes, dans lequel le circuit d'alimentation comprend un convertisseur de tension, un convertisseur de tension à condensateur commuté, un régulateur de tension ou un régulateur de tension entièrement intégré.
